# EUROPEAN PATENT APPLICATION

(11) **EP 4 756 281 A1**
(43) Date of publication of application: **10.06.2026**
(21) Application number: 25164003.3
(22) Date of filing: 16.03.2025
(51) Int. Cl.: F21K 9/00, H05K 1/14, F21Y 107/50, F21Y 107/60, F21Y 115/10, F21Y 103/33, F21Y 113/00

(54) **LAMINATED LED LIGHT-EMITTING MODULE, ILLUMINATING LAMP, AND PREPARATION METHOD THEREOF**

(30) Priority: 04.12.2024 CN 202411772249
(71) Applicant: Nitelab Optoelectronics Co., Ltd., Foshan, Guangdong 528251 (CN)
(72) Inventor: LI, Wenjie, Foshan, Guangdong, 528251 (CN)
(74) Representative: KIPA AB

(57) **Abstract**

A laminated LED light-emitting module, a illuminating lamp, and a preparation method thereof are provided. The laminated LED light-emitting module includes a plurality of laminated substrates, one substrate of the plurality of substrates is arranged with a first area, and other substrates of the plurality of substrates are each arranged with an annular area; and the first area is arranged with LED beads, and the each annular area is arranged with a plurality of LED beads; in an orthographic projection of the plurality of substrates on a horizontal plane, inner contours of the annular areas gradually increase in size from inside to outside, with each inner contour sequentially enclosing a previous one; in the orthographic projection on the horizontal plane, the orthographic projection of the first area is arranged within the orthographic projection of an innermost annular area. The present disclosure reduces cost, volume, and weight of illuminating lamps.

## Description

### FIELD

The present disclosure relates to the technical field of mobile lighting, in particular to a laminated LED light-emitting module, a illuminating lamp, and a preparation method thereof.

### BACKGROUND

In mobile lighting, in order to meet more lighting requirements, light beams can often be transformed in lighting fixtures, that is, different light beams can be switched to meet different lighting requirements.

At present, when performing beam transformation in lighting fixture, one way is to enable a change in the distance between the lens and the light source in the lighting fixture, thus, beam transformation is achieved by adjusting the distance between the lens and the light source. Another way is to set a plurality of LED light sources at different positions on the same focal plane, and when the light beam is transformed, the LED light sources at different positions on the same focal plane are driven to realize the light beam transformation. In the above two ways, although the beam can be transformed, the structure is complex, which makes the cost of the illumination lamps high and the volume and weight of the illumination lamps large.

Therefore, the existing technology needs to be improved and developed.

### SUMMARY

In view of the shortcomings of the prior art, the purpose of the present disclosure is to provide a laminated LED light-emitting module, a illuminating lamp, and a preparation method thereof, to solve the problems associated with existing lighting fixtures, where the structures used for beam transformation are overly complex, resulting in higher costs and increased size and weight.

In order to solve the problems, the present disclosure adopts the following schemes. The present disclosure provides a laminated LED light-emitting module, including: a plurality of laminated substrates, where one substrate of the plurality of substrates is arranged with a first area, and other substrates of the plurality of substrates are each arranged with an annular area; and the first area is arranged with a LED bead, and each of the annular area is arranged with a plurality of LED beads;
in an orthographic projection of the plurality of substrates on a horizontal plane, inner contours of the annular areas of the other substrates with the annular areas gradually increase in size from inside to outside, with each inner contour sequentially enclosing a previous one; in the orthographic projection on the horizontal plane, the orthographic projection of the first area is arranged within the orthographic projection of an innermost annular area; an emitted light beam from a lighten LED bead on any one substrate is not obstructed by other substrates, making the lighten LED bead on the any one substrate emits the light beam with an angle correspondingly.

Further, the one substrate with the first area is arranged at a top of the plurality of laminated substrates; outer contours of the plurality of laminated substrates gradually decrease from bottom to top, and the one substrate with the first area is arranged in the annular area of adjacent substrate; in two up-and-down adjacent-arrangement substrates with the annular areas, an upper substrate is arranged in the annular area of an lower substrate.

Further, the one substrate with the first area is arranged at a bottom of the plurality of laminated substrates; the other substrates with the annular areas are each arranged with a first through hole penetrating an upper surface and a lower surface of the each substrate with the annular area; the first through holes are each arranged in the annular area of the corresponding substrate; a projection of the first area on an adjacent substrate is arranged within the first through hole of the adjacent substrate; when a plurality of substrates with the first through holes are arranged, inner contours of the first through holes gradually increase in size from bottom to top, and projections of the first through holes on the plane are sequentially enclosing a previous one; wherein in two up-and-down adjacent-arrangement substrates with the first through holes, a projection of the annular area of a lower substrate with the first through hole on an upper substrate with the first through hole is arranged in the first through hole of the upper substrate with the first through hole; the first area on the one substrate with the first area is projected on the adjacent substrate and arranged in the first through hole on the adjacent substrate.

Further, heat-conducting glue is filled between the two up-and-down adjacent-arrangement substrates; or the two up-and-down adjacent-arrangement substrates are welded by reflow solder.

Further, in the each other substrate with the annular area, a distance between two adjacent-arrangement LED beads of the plurality of LED beads along a clockwise or counterclockwise direction is equal.

Further, the LED bead of the first area and the plurality of LED beads of the each annular area are all white LED beads, and a power of the LED bead of the first area is greater than a power of the LED beads of the each annular area.

Further, electrodes on the one substrate with the first area are arranged at any position of the one substrate with the first area outside the first area;
electrodes on the each other substrate with the annular area are arranged at any position of the each other substrate with the annular area outside the annular area.

Further, when the one substrate with the first area is arranged at the bottom of the plurality of laminated substrates, the outer contours of the plurality of laminated substrates gradually increase in size from bottom to top.

The present disclosure further provides an illumination lamp, the illumination lamp includes the laminated LED light-emitting module.

The present disclosure further provides a preparation method for the laminated LED light-emitting module, the preparation method includes:
providing a plurality of substrates, where one substrate of the plurality of substrates is arranged with a first area, and other substrates of the plurality of substrates are each arranged with an annular area;
arranging a LED bead in the first area of the one substrate with the first area;
arranging a plurality of LED beads in the annular area of the each other substrate with the annular area;

laminating the one substrate and the other substrates; where in an orthographic projection of the plurality of substrates on a horizontal plane, inner contours of the annular areas of the other substrates with the annular areas gradually increase in size from inside to outside, with each inner contour sequentially enclosing a previous one; in the orthographic projection on the horizontal plane, the orthographic projection of the first area is arranged within the orthographic projection of an innermost annular area; an emitted light beam from a lighten LED bead on any one substrate is not obstructed by other substrates, making the lighten LED bead on the any one substrate emits the light beam with an angle correspondingly.

### Beneficial effects:

The present disclosure provides a laminated LED light-emitting module, a illuminating lamp, and a preparation method thereof. The laminated LED light-emitting module includes a plurality of laminated substrates, where one substrate of the plurality of substrates is arranged with a first area, and other substrates of the plurality of substrates are each arranged with an annular area; and the first area is arranged with a LED bead, and each of the annular area is arranged with a plurality of LED beads; in an orthographic projection of the plurality of substrates on a horizontal plane, inner contours of the annular areas gradually increase in size from inside to outside, with each inner contour sequentially enclosing a previous one; in the orthographic projection on the horizontal plane, the orthographic projection of the first area is arranged within the orthographic projection of an innermost annular area; an emitted light beam from a lighten LED bead on any one substrate is not obstructed by other substrates, making the lighten LED bead on the any one substrate emits the light beam with an angle correspondingly. In the schemes of the present disclosure, since the inner contours of the annular areas gradually increase in size from inside to outside, with each inner contour sequentially enclosing a previous one; in the orthographic projection on the horizontal plane, the orthographic projection of the first area is arranged within the orthographic projection of an innermost annular area; an emitted light beam from a lighten LED bead on the any one substrate is not obstructed by another substrates. Therefore, the lighten LED bead of the each substrate of the laminated LED light-emitting module emits a light beam with an angle correspondingly, achieving beam transformation and reducing the cost of lighting fixtures, while also decreasing size and weight.

### BRIEF DESCRIPTION OF THE DRAWINGS

In order to make the technical schemes of the embodiments of the present disclosure or the schemes of the prior art clearer, the attached drawings in the embodiments of the present disclosure or the prior art are briefly described here. Obviously, the described attached drawings are only a part of the embodiments of the present disclosure. Those skilled in the art with no inventive labor can obtain other attached drawings according to the present drawings.
FIG. 1 is a structural diagram of one substrate with the first area arranged at a top of a plurality of substrates according to the present disclosure.
FIG. 2 is a front view of the one substrate with the first area arranged at the top of the plurality of substrates in one embodiment of the present disclosure.
FIG. 3 is a top view of the one substrate with the first area arranged at the top of the plurality of substrates in one embodiment of the present disclosure.
FIG. 4 is a structural diagram of the one substrate with the first area arranged at the top of the plurality of substrates in one embodiment of the present disclosure.
FIG. 5 is a top view of the one substrate with the first area arranged at the top of the plurality of substrates in one embodiment of the present disclosure.
FIG. 6 is a top view of a substrate arranged with an annular area corresponding to the one substrate with the first area arranged at the top of the plurality of substrates in one embodiment of the present disclosure.
FIG. 7 is a structural diagram of the one substrate with the first area arranged at a bottom of the plurality of substrates in one embodiment of the present disclosure.
FIG. 8 is a front view of the one substrate with the first area arranged at the bottom of the plurality of substrates in one embodiment of the present disclosure.
FIG. 9 is a top view of the one substrate with the first area arranged at the bottom of the plurality of substrates in one embodiment of the present disclosure.
FIG. 10 is a top view of the one substrate with the first area arranged at the bottom of the plurality of substrates in one embodiment of the present disclosure.
FIG. 11 is a top view of a substrate with the annular area corresponding to the one substrate with the first area arranged at the bottom of the plurality of substrates.
Attached drawing marks: 101-substrate; 102-LED bead; 103-first through hole.

### DETAILED DESCRIPTION OF EMBODIMENTS

In the description of the present disclosure, it should be understood that the orientation or position relationship indicated by the terms "front", "rear", "upper", "lower", "left", "right", "longitudinal", "transverse", "vertical", "horizontal", "top", "bottom", "inner", "outer", "head", "tail" etc. is based on the orientation or position relationship shown in the attached drawings, which is only for the convenience of describing the present disclosure and simplifying the description, and is not indicated or implied that the devices or elements referred to must have a specific orientation, be constructed and operate in a specific orientation, and therefore should not be construed as limitations of the present disclosure.

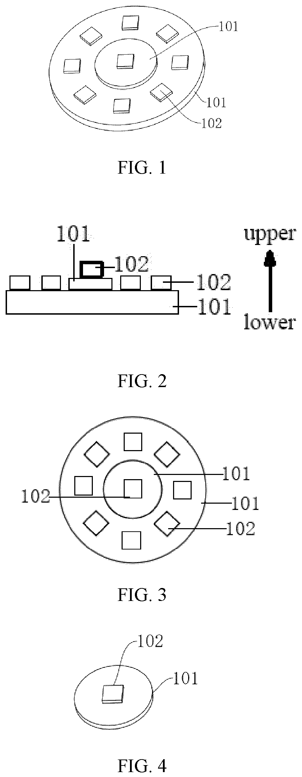

As shown in FIG. 1, FIG. 2, FIG. 3, FIG. 7, FIG. 8, and FIG. 9, the present disclosure provides a laminated LED light-emitting module, which includes a plurality of laminated substrates 101, one substrate 101 of the plurality of substrates 101 is arranged with a first area, and other substrates 101 of the plurality of laminated substrates 101 are each arranged with an annular area, and a LED bead 102 is arranged in the first area. Each annular area is arranged with a plurality of LED beads 102. In an orthographic projection of the plurality of substrates 101 on a horizontal plane, inner contours of the annular areas gradually increase in size from inside to outside and are sequentially stacked; in the orthographic projection on the horizontal plane, the orthographic projection of the first area is arranged within the orthographic projection of an innermost annular area; an emitted light beam from a lighten LED bead 102 on any one substrate is not obstructed by other substrates, making the lighten LED bead 102 on the any one substrate emits the light beam with an angle correspondingly.

When the substrate 101 is arranged, the substrate 101 can be arranged with two layers, three layers, four layers, etc. Therefore, a layer quantity of the substrates 101 is not specifically limited. The substrate 101 can be arranged in a circular plate structure, a square plate structure, and a rhombus plate structure, and the specific structure of the substrate 101 can be determined by those skilled in the art according to actual needs.

In the embodiment, since inner contours of the annular areas of the other substrates 101 with the annular areas gradually increase in size from inside to outside, with each inner contour sequentially enclosing a previous one; and in the orthographic projection on the horizontal plane, the orthographic projection of the first area of the one substrate 101 with the first area is arranged within the orthographic projection of an innermost annular area of the other substrates 101 with the annular areas; and an emitted light beam from a lighten LED bead 102 on any one substrate is not obstructed by other substrates, making the lighten LED bead 102 on the any one substrate emits the light beam with an angle correspondingly, which realizes light beam transformation through one laminated LED light-emitting module, and reduces the cost, volume, and weight of the illumination lamp.

When the lighten LED bead 102 on the one substrate 101 emits the light beam with an angle correspondingly, it means emitted angles of the lighten LED beads 102 on different substrates 101 are different. The horizontal plane refers to a plane parallel to the upper or lower surface of the substrates 101.

In some embodiments, as shown in FIG. 1, FIG. 2, FIG. 3, FIG. 4, FIG. 5, and FIG. 6, the one substrate 101 with the first area is arranged at a top of the plurality of laminated substrates 101. When the one substrate 101 with the first area is arranged at the top of the plurality of laminated substrates 101, outer contours of the plurality of laminated substrates 101 gradually decrease from bottom to top. The one substrate 101 with the first area is arranged in the annular area of adjacent substrate 101. In two up-and-down adjacent-arrangement substrates 101, an upper substrate 101 is arranged in the annular area of a lower substrate 101.

When the one substrate 101 with the first area is arranged at the top of the plurality of laminated substrates 101, since the substrate 101 at an upper adjacent position is located within the annular area of the substrate 101 at a lower adjacent position, and the plurality of LED beads 102 are arranged within the annular area of the each other substrate with the annular area 101. Therefore, when the LED beads 102 on any one substrate 101 with the annular area are lighten, the LED beads 102 on the any one substrate 101 with the annular area can not be obstructed by any other substrates 101 with the annular areas. Further, the one substrate 101 with the first area is arranged within the annular area of the adjacent substrate 101 with the annular area, thus emitted beam by the lighten LED beads 102 on the any other substrates 101 with the annular areas can not be obstruct by the one substrate 101 with the first area. Further, the one substrate 101 with the first area is arranged at the top of the plurality of laminated substrates 101, therefore when the LED bead 102 on the one substrate 101 with the first area is lighten, no obstruction can be formed. In summary, the lighten LED bead 102 on each substrate 101 emits the light beam with an angle correspondingly.

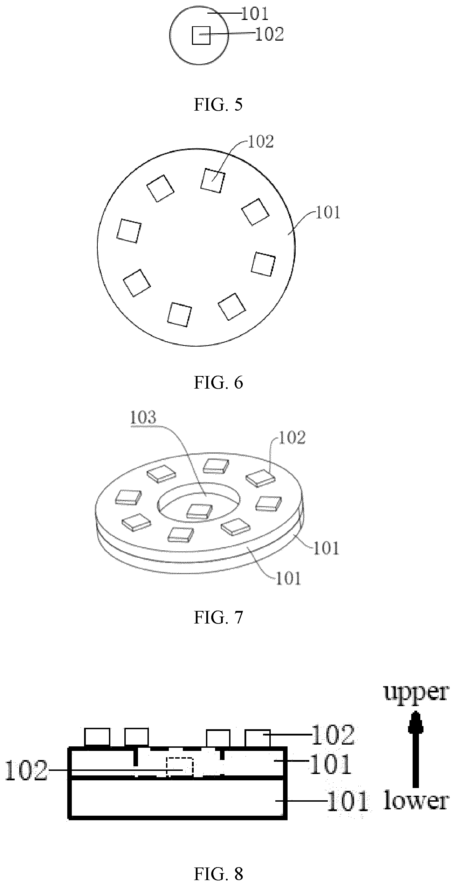

In some embodiments, as shown in FIG. 7, FIG. 8, FIG. 9, FIG. 10 and FIG. 11, the one substrate 101 with the first area is arranged at the bottom of the plurality of laminated substrates 101. When the one substrate 101 with the first area is arranged at the bottom of the plurality of laminated substrates 101, the other substrates 101 with the annular areas are each arranged with a first through hole 103 penetrating an upper surface and a lower surface of the each other substrate 101 with the annular area. The first through holes 103 are each arranged in the annular area of the corresponding other substrate 101, and a projection of the first area of the one substrate 101 with the first area on an adjacent substrate 101 is arranged within the first through hole of the adjacent substrate 101. When a plurality of other substrates 101 with the annular areas are arranged, inner contours of the first through holes 103 on the plurality of other substrates 101 with the annular areas with the first through holes 103 gradually increase in size from bottom to top, and projections of the first through holes on the plurality of other substrates 101 with the annular areas on the plane are sequentially enclosing a previous one. In two up-and-down adjacent-arrangement substrates 101 arranged with the first through holes 103, a projection of the annular area of a lower substrate 101 with the first through hole 103 on an upper substrate 101 with the first through hole 103 is arranged within the first through hole 103 of the upper substrate 101 with the first through hole 103.

When the one substrate 101 with the first area is arranged at the bottom of the plurality of laminated substrates 101, a first through hole 103 penetrating the upper surface and the lower surface of the substrate 101 are arranged on the each substrate 101 arranged with the annular area, and the first through hole 103 is arranged within the annular area of the corresponding substrate 101. When the plurality of substrates 101 with the annular areas are arranged, the inner contours of the first through holes 103 of the plurality of substrates 101 with the annular areas gradually increase in size from bottom to top, and the projections of the first through holes 103 on the plane are sequentially enclosing a previous one. In two up-and-down adjacent-arrangement substrates 101 arranged with the first through holes 103, the projection of the annular area of the lower substrate 101 is arranged in the first through hole 103 of the upper substrate 101, and the first area of the one substrate 101 with the first area is projected on the adjacent substrate 101 with the annular area and arranged within the first through hole 103 of the adjacent substrate 101, so when the LED bead 102 of the each substrate 101 are lighten, the emitted beam can not be obstructed and emit the light beam with an angle correspondingly.

In the embodiment, the first through hole 103 can be arranged circular shaped, square shaped, and rhombus shaped, etc. The annular area can be arranged a circular annular area, a square annular area, a rhombus annular area, etc. When arranging the annular area, it is necessary to consider the arrangement scheme of the LED beads 102 of the substrates 101 with the annular areas, that is, to ensure that the LED beads 102 are located within the arranged annular area. In the substrate 101 shown in FIG. 7, FIG. 9 and FIG. 11, the annular area can be a regular circular annular area, making the LED beads 102 of the substrate 101 locate within the annular area. The first area is the area where the LED bead 102 is arranged on the one substrate 101 with the first area. As shown in FIG. 7, FIG. 8, FIG. 9, and FIG. 10, on the substrate 101, the first area is the area where the LED bead 102 is arranged.

It should be noted that the lower substrate 101 is the substrate 101 arranged lower in the two up-and-down adjacent-arrangement substrates 101, The upper substrate 101 is the substrate 101 arranged upper in the two up-and-down adjacent-arrangement substrates.

In one embodiment, as shown in FIG. 1 and FIG. 2, the substrate 101 is arranged with two layers, and the substrate 101 with the first area is arranged at the top of the two substrates 101, where the LED bead 102 is arranged at the upper substrate 101 (the area where the LED bead 102 is arranged is the first area). A plurality of LED beads 102 are arranged at the lower substrate 101 in a circumferential direction (an annular area formed by connecting the LED beads 102 in sequence is the mentioned annular area). As shown in FIG. 1 and FIG. 2, when the plurality of LED beads 102 of the substrate 101 with the annular area is lighten, the emitted beams can not be obstructed, and when the LED bead 102 of the substrate 101 with the first area is lighten, the emitted beam can not be obstructed. Therefore, when the laminated LED light-emitting module 101 is arranged with two layers of substrates 101, the LED beads 102 on different substrates 101 can be lighten as needed, and the light beam transformation can be realized.

In another embodiment, as shown in FIG. 7 and FIG. 8, the substrate 101 is arranged with two layers, and the one substrate 101 with the first area is arranged at the bottom of the two substrates 101. Similarly, as shown in FIG. 7 and FIG. 8, when the plurality of LED beads 102 of the other substrates 101 with the annular areas are lighten, the emitted beams can not be obstructed. The emitted light of the LED bead 102 on the first area is emitted through the first through hole 103 in the adjacent substrate 101, and can not be obstructed. Therefore, when the laminated LED light-emitting module with two-layer substrates 101 is applied, the LED beads 102 on different substrates 101 can be lighten as needed, so that the beam transformation can be realized.

In some embodiments, when the up-and-down adjacent-arrangement substrates 101 are connected, heat-conducting glue is filled between the upper and lower adjacent substrates 101, and two up-and-down adjacent-arrangement substrates 101 is glued together by heat-conducting glue. Of course, two up-and-down adjacent-arrangement substrates 101 can also be welded together by reflow solder.

In one embodiment, the up-and-down adjacent-arrangement substrates 101 are glued together by the heat-conducting glue, where the heat-conducting glue is conductive silver glue, but not limited to thermally conductive silver glue.

In the embodiment, the up-and-down adjacent-arrangement substrates 101 are connected by the heat-conducting glue, the heat generated by the laminated LED light-emitting module can be transferred from the substrate 101 to the heat-conducting glue from top to bottom, and then transferred from the heat-conducting glue to the lower substrate 101 to dissipate heat.

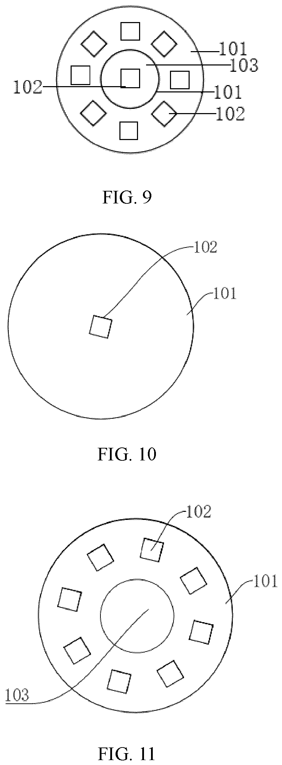

In some embodiments, as shown in FIG. 6 and FIG. 11, when the plurality of LED beads 102 are arranged on the substrate 101 with the annular area, a distance between two adjacent-arrangement LED beads 102 of the plurality of LED beads along a clockwise or counterclockwise direction 102 is equal.

In the embodiment, the arrangement that the distance between two adjacent-arrangement LED beads 102 of the plurality of LED beads 102 along a clockwise or counterclockwise direction is equal can make the substrate 101 more concise and beautiful, and make the luminous effect more uniform when the plurality of LED beads 102 in the annular area are lighten.

In some embodiments, the LED bead 102 in the first area and the plurality of LED beads 102 in the annular areas are all white LED beads 102, a power of the LED bead 102 in the first area is greater than a power of the LED beads 102 in each annular area.

When the laminated LED light-emitting module is applied, the LED bead 102 in the first area is arranged at a focus of a condenser lens or a reflector cup of the lighting fixtures. Since the power of the LED bead 102 in the first area is greater than the power of the LED beads 102 in each annular area, the LED bead 102 in the first area can be lighten when it is necessary to illuminate a front target with a small long-distance field of view. Further, since the LED bead 102 in the first area is arranged at the focus of the condenser lens or the reflector cup, forming a bright light with a small divergent angle. When it is necessary to illuminate the target near ahead and with a large field of view, the LED beads 102 on the corresponding substrate 101 with the annular area are illuminated as required, and the illuminated LED beads 102 pass through the condenser lens or reflector cup and then stack at a large angle in the front to illuminate a large range of scenes in front, so as to meet different lighting application requirements.

In some embodiments, electrodes on the one substrate 101 with the first area are arranged at any position outside the first area on the one substrate 101 with the first area. Electrodes on the each other substrate with the annular area 101 are arranged at any position outside the annular area on the each the other substrates 101 with the annular areas.

In the embodiment, when the electrodes are arranged, the electrodes are arranged at any position on the substrate 101 without affecting the light emission and installation of the LED beads 102. Specifically, when the electrodes are arranged on the one substrate 101 with the first area, the electrodes are arranged on the same side as the LED bead 102 on the one substrate 101 with the first area, or on the opposite side of the LED bead 102 on the one substrate 101 with the first area. When the electrodes are arranged on the substrate 101 with the annular area, the electrodes can be arranged on the same side as the LED beads 102 on the substrate 101 with the annular area, or on the opposite side of the LED beads 102 on the substrate 101 with the annular area. Thus, the arrangement mode of the electrodes is flexible, and the electrodes include a positive electrode and a negative electrode.

In some embodiments, when the one substrate 101 with the first area is arranged at the bottom of the plurality of substrates 101, in order to further reduce the cost, volume, and weight of the lighting fixtures using the laminated LED light-emitting module, the outer contours of the plurality of substrates 101 gradually increase in size from bottom to top.

In the embodiment, when the one substrate 101 with the first area is arranged at the bottom of the plurality of substrates 101, the outer contours of the plurality of substrates 101 gradually increase in size from bottom to top, so that the cost of the laminated LED light-emitting module is further reduced, and at the same time, the volume and weight are further reduced.

In some embodiments, the substrates 101 are, but not limited to, ceramic substrates 101.

In some embodiments, the present disclosure further provides an illumination lamp, which includes the laminated LED light-emitting module.

The illumination lamp is an illumination lamp with a condenser lens or a reflector cup. When the laminated LED light-emitting module is applied on the illumination lamp with the condenser lens or the reflector cup, the LED bead 102 on the one substrate 101 with the first area are arranged at the focus of the condenser lens or reflector cup, the LED beads 102 on the other substrates 101 with the annular areas are arranged in front of or behind a focal plane. When it is necessary to illuminate the front target with a small long-distance field of view angle, the LED bead 102 in the first area can be lighten (the LED beads 102 can be arranged with a high-power white LED beads 102). Further, since the LED bead 102 in the first area is arranged at the focus of the condenser lens or the reflector cup, a strong light beam is formed with a small divergence angle after lighting. When it is necessary to illuminate a target with a near front and a wide field of view, the corresponding LED beads 102 on the substrate 101 with a ring-shaped area are lighten as required, and the lighten LED beads 102 are superimposed at a large angle in front after passing through a condenser lens or a reflective cup, so as to illuminate a large-scale scene in front, thus meeting different lighting application requirements.

It can be seen that when the laminated LED light-emitting module is applied to the illumination lamp, the illumination lamp can perform beam transformation (lighting the LED beads 102 on different substrates 101 as required) through one laminated LED light-emitting module, so that the cost, volume and weight of the illumination lamp are reduced.

In some embodiments, the present disclosure also provides a preparation method for the laminated LED light-emitting module as described above, which includes:
S1, providing a plurality of substrates, where one substrate of the plurality of substrates is arranged with a first area, and other substrates of the plurality of substrates are each arranged with an annular area;
S2, arranging a LED bead in the first area of the one substrate with the first area;
S3, arranging a plurality of LED beads in the annular area of the each other substrate with the annular area;
S4, laminating the one substrate with the first area and the other substrates with the annular areas; where in an orthographic projection of the plurality of substrates on a horizontal plane, inner contours of the annular areas of the other substrates with the annular areas gradually increase in size from inside to outside, with each inner contour sequentially enclosing a previous one; in the orthographic projection on the horizontal plane, the orthographic projection of the first area is arranged within the orthographic projection of an innermost annular area; an emitted light beam from a lighten LED bead on any one substrate is not obstructed by other substrates, making the lighten LED bead on the any one substrate emits the light beam with an angle correspondingly.

In the embodiment, the LED bead is paste arranged on the one substrate, and the arranged position is regarded as the first area. An annular area is arranged on the each other substrate; after the annular areas are determined, a plurality of LED beads are arranged on the each annular area. Then, the substrate with the first area and the substrate with the annular area are sequentially stacked, where heat-conducting glue can be filled between two adjacent substrates, and the two substrates can be glued together by heat-conducting glue, or the two adjacent substrates can be welded together by reflow solder, which can be determined according to the actual situation.

When the substrates are stacked, in an orthographic projection of the plurality of substrates on a horizontal plane, inner contours of the annular areas of the other substrates with the annular areas gradually increase in size from inside to outside, with each inner contour sequentially enclosing a previous one; in the orthographic projection on the horizontal plane, the orthographic projection of the first area of the one substrate with the first area is arranged within the orthographic projection of an innermost annular area; emitted light beams from a lighten LED bead on any one substrate is not obstructed by another substrates, making the lighten LED bead on the any one substrate emit the light beams with an angle correspondingly.

When the substrate is arranged, the substrate can be arranged with two layers, three layers, four layers, etc. Therefore, a layer quantity of the substrates is not specifically limited. The substrate can be arranged in a circular plate structure, a square plate structure, and a rhombus plate structure, and the specific structure of the substrate can be determined by those skilled in the art according to actual needs.

Therefore, when the LED bead on the any one substrate of the laminated LED light-emitting module are lighten, a light beam with an angle is emitted correspondingly, so that the illumination lamp can realize light beam transformation through one laminated LED light-emitting module, which reduces the cost, volume, and weight of the illumination lamp.

It should be pointed out that the above description of the embodiment of the illumination lamp and the preparation method is similar to that of the embodiment of the above-mentioned laminated LED light-emitting module, and has similar beneficial effects as the above-mentioned laminated LED light-emitting module. For the technical details not disclosed in the embodiment of the illumination lamp and the preparation method, please refer to the description of the embodiment of the laminated LED light-emitting module of the present disclosure.

To sum up, the present disclosure provides a laminated LED light-emitting module, an illumination lamp and a preparation method thereof, which have the following beneficial effects:
Since the inner contours of the annular areas of the other substrates 101 with the annular areas gradually increase in size from inside to outside, with each inner contour sequentially enclosing a previous one; and in the orthographic projection on the horizontal plane, the orthographic projection of the first area of the one substrate 101 with the first area is arranged within the orthographic projection of an innermost annular area of the other substrates 101 with the annular areas; an emitted light beam from a lighten LED bead 102 on any one substrate is not obstructed by other substrates, making the lighten LED bead 102 on the any one substrate emits the light beam with an angle correspondingly, which achieves beam transformation while reducing the cost, size, and weight of the lighting fixtures.

It should be understood that the above embodiments are only preferred embodiments of the present disclosure, with more specific and detailed description. But it cannot be understood as a limitation on the scope of the present disclosure. It should be noted that, for those ordinary skilled in the art, it is possible to freely combine the technical features without departing from the concept of the present disclosure. Several modifications and improvements can also be made, all of which fall within the scope of protection of the present disclosure. Therefore, any equivalent transformations and modifications made according to the claims of the present disclosure are also covered by the scope of the claims.

## Claims

1. A laminated LED light-emitting module, comprising: a plurality of laminated substrates, wherein one substrate of the plurality of substrates is arranged with a first area, and other substrates of the plurality of substrates are each arranged with an annular area; and the first area is arranged with a LED bead, and each of the annular area is arranged with a plurality of LED beads;
wherein in an orthographic projection of the plurality of substrates on a horizontal plane, inner contours of the annular areas of the other substrates with the annular areas gradually increase in size from inside to outside, with each inner contour sequentially enclosing a previous one; in the orthographic projection on the horizontal plane, the orthographic projection of the first area is arranged within the orthographic projection of an innermost annular area; an emitted light beam from a lighten LED bead on any one substrate is not obstructed by other substrates, making the lighten LED bead on the any one substrate emits the light beam with an angle correspondingly.

2. The laminated LED light-emitting module according to claim 1, wherein the one substrate with the first area is arranged at a top of the plurality of laminated substrates; outer contours of the plurality of laminated substrates gradually decrease from bottom to top, and the one substrate with the first area is arranged in the annular area of adjacent substrate; in two up-and-down adjacent-arrangement substrates with the annular areas, an upper substrate is arranged in the annular area of an lower substrate.

3. The laminated LED light-emitting module according to claim 1, wherein the one substrate with the first area is arranged at a bottom of the plurality of laminated substrates; the other substrates with the annular areas are each arranged with a first through hole penetrating an upper surface and a lower surface of the each substrate with the annular area; the first through holes are each arranged in the annular area of the corresponding substrate; a projection of the first area on an adjacent substrate is arranged within the first through hole of the adjacent substrate; when a plurality of substrates with the first through holes are arranged, inner contours of the first through holes gradually increase in size from bottom to top, and projections of the first through holes on the plane are sequentially enclosing a previous one; wherein in two up-and-down adjacent-arrangement substrates with the first through holes, a projection of the annular area of a lower substrate with the first through hole on an upper substrate with the first through hole is arranged in the first through hole of the upper substrate with the first through hole; the first area on the one substrate with the first area is projected on the adjacent substrate and arranged in the first through hole on the adjacent substrate.

4. The laminated LED light-emitting module according to any one of claims 1-3, wherein heat-conducting glue is filled between the two up-and-down adjacent-arrangement substrates; or the two up-and-down adjacent-arrangement substrates are welded by reflow solder.

5. The laminated LED light-emitting module according to claim 2 or 3, wherein in the each other substrate with the first area, a distance between two adjacent-arrangement LED beads of the plurality of LED beads along a clockwise or counterclockwise direction is equal.

6. The laminated LED light-emitting module according to claim 5, wherein the LED bead of the first area and the plurality of LED beads of the each annular area are all white LED beads, and a power of the LED bead of the first area is greater than a power of the LED beads of the each annular area.

7. The laminated LED light-emitting module according to claim 6, wherein electrodes on the one substrate with the first area are arranged at any position of the one substrate with the first area outside the first area;
electrodes on the each other substrate with the first area are arranged at any position of the each other substrate with the annular area outside the annular area.

8. The laminated LED light-emitting module according to claim 3, wherein when the one substrate with the first area is arranged at the bottom of the plurality of laminated substrates, the outer contours of the plurality of laminated substrates gradually increase in size from bottom to top.

9. An illumination lamp, wherein the illumination lamp comprises the laminated LED light-emitting module according to any one of claims 1-8.

10. A preparation method for the laminated LED light-emitting module according to any one of claims 1-8, wherein the preparation method comprises:
providing a plurality of substrates, wherein one substrate of the plurality of substrates is arranged with a first area, and other substrates of the plurality of substrates are each arranged with an annular area;
arranging a LED bead in the first area of the one substrate with the first area;
arranging a plurality of LED beads in the annular area of the each other substrate with the annular area;
laminating the one substrate and the other substrates; wherein in an orthographic projection of the plurality of substrates on a horizontal plane, inner contours of the annular areas of the other substrates with the annular areas gradually increase in size from inside to outside, with each inner contour sequentially enclosing a previous one;
in the orthographic projection on the horizontal plane, the orthographic projection of the first area is arranged within the orthographic projection of an innermost annular area; an emitted light beam from a lighten LED bead on any one substrate is not obstructed by other substrates, making the lighten LED bead on the any one substrate emits the light beam with an angle correspondingly.
